# EUROPEAN PATENT SPECIFICATION

(11) **EP 0 303 036 B1**
(45) Date of publication and mention of the grant of the patent: **19.05.1993**
(21) Application number: 88110294.1
(22) Date of filing: 28.06.1988
(51) Int. Cl.: H01L 39/24, H01L 39/14, B32B 18/00

(54) **Electrically superconducting metal-ceramic coatings**
Metallkeramische supraleitende Beschichtungen
Revêtements métal-céramique supraconducteurs

(30) Priority: 13.08.1987 US 85055
(43) Date of publication of application: 15.02.1989
(73) Proprietor: International Business Machines Corporation, Armonk, N.Y. 10504 (US)
(72) Inventor: Brown, Charles Allan, San José, Ca 95123 (US); Engler, Edward Martin, San José, Ca 95123 (US); Lee, Victor Yee-Way, San José, Ca 95120 (US)
(74) Representative: Burt, Roger James, Dr.

(56) References cited:
- EP-A- 0 292 126
- EP-A- 0 299 796
- US-A- 4 110 515
- JAPANESE JOURNAL OF APPLIED PHYSICS, vol. 26, no. 5, May 1987, part 2, pages L761-L762, Tokyo, JP; H. KOINUMA et al.: "High Tc superconductivity in screen printed Yb-Ba-Cu-O films"
- Advanced Ceramic Materials, vol. 2, no. 38, July 1987, pp.388-400

## Description

The present invention is concerned with substrates coated with composites of metals and superconducting ceramics and with the preparation of such composite coatings. The coatings are durable, adherent and continuous as well as superconducting above 77 K.

The technical breakthrough of Bednorz and Muller [Z. Phys. B, 64, 189 (1986)] was the first major improvement in superconducting transition temperature (T_{c}) in the last decade. This material was a compound of nominal composition La₂₋ₓMₓCuO_{y} where M=Ca, Sr or Ba, typically 0 < x < 0.3 and y varies with preparation conditions. Subsequently it was reported by Wu et al. [Phys. Rev. Letters, 58, 908 (1987)] that the material of the composition Y_{1.2} Ba_{0.8} CuO_{y} showed the onset of superconductivity in the mid-ninety degree Kelvin range. Engler et al. [J. Amer. Chem. Soc, Vol. 109, No. 9, 1987, p. 2848] reported superconducting materials having the composition Y₁Ba₂Cu₃O_{y} where y is sufficient to satisfy the valence requirements of the metals. Engler et al. showed that a variety of superconducting materials could be prepared with the general composition AM₂Cu₃O_{y}, where A was yttrium and/or one or more elements of the lanthanum group (that is, La, Nd, Sm, Eu, Gd, Dy, Ho, Er, Tm, Yb, Lu) and M was one ore more elements of the group Ca, Sr, and Ba. Furthermore, the superconducting properties of these materials are very sensitive to their processing conditions.

Prior art including, for example, [U.S. Patent 4,001,146], shows the application of conductor patterns on substrates using metal powder and various metal oxides. U.S. Patent 4,183,746 shows mixtures of ceramic materials and metals; these compositions are useful in glass making. IBM TECHNICAL DISCLOSURE BULLETIN, Vol. 8, No. 10, March 1986, page 1462, shows an electro paste having increased adhesion. The electro paste includes metal particles, oxides and an organic vehicle. Patent application GB-A-2,072,707 shows an electro conductive paste for metallising, containing metal, metal oxides, a binding agent and a solvent. The mentioned references are merely typical of a very large amount of such prior art dealing with metals and ceramics or metal oxides. European Patent Application EP-A-0,292,126 (relevant only under Article 54(3)EPC) discloses a substrate with a metal layer and a superconductive coating including superconductive material and metal. Koinuma et al. [Japanese Journal of Applied Physics, Vol. 26, No. 5, pp L761 - 762] showed the use of screen printing of a superconducting film on a substrate.

It has now been found that finely divided superconducting ceramic particles, when mixed with specific formulations of a metal in the finely divided state, with a fluorinated organic polymer, and with an organic solvent, form a coating mixture which can be used to coat substrates with durable, adherent and continuous coatings which are also electrically superconductive above 77 K. The superconducting behaviour is shown by four probe resistive measurements and also the Meissner effect. The onset of superconductivity and the transition range can be comparable to those of the underlining ceramic superconducting material and superconductivity can be observed in both bulk and thin film samples at a temperature comparable to that observed for the ceramic powder itself.

The preparation of composites of a metal which is a good electrical conductor and of a superconductor is important for current carrying applications; in the event of a momentary lapse in superconductivity due to transient high magnetic field or other reasons, the matrix of the conductive metal provides a path for the currents present, and prevents the excessive resistive heating which would occur in the superconductor above T_{C}. Superconductors of niobium alloys commonly use a copper shell to provide such a momentary current shunt. Superconducting ceramics are hard brittle materials and thus difficult to process and handle, especially in thin sections. A composite, like that produced by the process of the present invention, which retains the superconductive properties with improvements in the mechanical properties facilitates fabrication. Obtaining superconductivity in the composites is dependent upon the formulation and composition of the coatings. The process and compositions described here are required to achieve the above advantages (current shunt and processability of coatings) while preserving superconductivity above 77 K.

In the process of the present invention, finely ground superconducting ceramic and metal particles are mixed in an organic solvent with a fluorinated organic polymer. The metal is typically present in from about 10 to 40% by weight of the superconducting ceramic. The most preferred amount is about 20%. Both the ceramic and the metal are present as finely divided particles, preferably less than 10 microns in diameter, and most preferably less than one micron. The mixture can be made either by simple mixing of powders individually or grinding the two particles together. The superconducting ceramic can be any of the known ceramic superconducting materials, some of which have been referenced above.

A fluorinated organic polymer is used as a binder. The polymer should be soluble in the organic solvent which is used as the suspension medium. The most preferred polymers are fluoroalcohol-acrylic acid esters. An example of such a material is poly(perfluoroalkyl acrylate). Such a material is commercial available under the trademark VITON. In general, the preferred amount of organic polymer is from about 10% to about 30% of the weight of the ceramic.

When so desired, a minor amount of a surfactant may be added to act as an aid to dispersion. The surfactant should be one that upon ignition leaves no ash. The surfactant available under the trademark TRITON has given good results. The use of a surfactant, however, is not an essential feature of the invention.

Silver, gold and tin are the preferred metals, most preferably silver. The substrate upon which the coating is applied should not react chemically with the coating in a way that destroys the superconductivity. The most preferred substrates are alumina, sapphire, barium titanate and magnesium oxide.

Any of a wide variety of organic solvents can be used. For example, acetone, butyl acetate, toluene and most preferably, methyl ethyl ketone. Mixtures of solvents can also be used.

In carrying out the process of the present invention, the finely divided superconducting ceramic, the finely divided metal and the fluorinated polymer are mixed with the organic solvent and applied to the substrate. The application can be by dipping the substrate in the mixture or by applying the mixture to the substrate by such conventional processes as spraying or spin coating. The mixture can simply be painted on the substrate. The solvent is removed by drying at a temperature of 20° to 100° C, and the material is then heated to about 400 ° C, and held there for from one to twelve hours to burn off the organic polymer. In some instances to improve the T_{c}, it is desired to anneal the resulting coating at 900° C in the presence of oxygen, followed by cooling at the rate of 100° C per hour to 300° C, while maintaining the oxygen atmosphere.

Prior to the annealing under oxygen, the mixture can be applied as a paint or ink to surfaces in layers or patterns before drying. Annealing the dried layer produces a durable, adherent and continuous superconductive coating. In thin film coatings, the film is much more adherent and mechanically resistant to abrasion than a coating of pure ceramic powder prepared by a similar means without the metal.

There are a wide variety of uses for superconductivity at liquid helium temperatures which are rendered cheaper and more convenient at liquid nitrogen temperatures. One of the major drawbacks of the ceramic superconducting materials is the difficulty of processing to give coatings which are not highly friable and do not require high vacuum techniques to produce. Another problem has been fabrication of superconductor materials which have a current shunt to allow a path for the superconducting currents in the event of a momentary loss of superconductivity, e.g., in the presence of a high magnetic field transient. Both of these difficulties are solved by the current invention. The retention of the Meissner effect in these composites, which form hard adherent coatings, allows their use for magnetic shielding applications.

The following Examples illustrate the present invention.

### Examples

A mixture consisting of 1.0 g superconducting powder of Y₁Ba₂Cu₃Oₓ, 0.3 g silver powder, 0.1 g perfluoroisobutyl acrylate polymer and 0.5 g methyl ethyl ketone was shaken in a vial with tungsten carbide ball on a mixer-shaker for 20 minutes to give a well dispersed paint. Both the superconducting oxide and the silver were used as very finely divided powders (1-5 µm) (micron) to facilitate particle dispersion. This mixture was applied onto sapphire substrates by either painting with a brush or spin coating at 3,000 rpm. The coated samples were air dried and heated to 250° C for six hours to evaporate off residual solvents. Further heating at 400° C for twelve hours removed the polymer binder. This was followed by annealing at 900° C in the presence of oxygen for 12-24 hours to give durable, adherent and continuous coatings with superconducting transitions near 90°K. The spin coated films are 15-20 µm (microns) thick while the brushed on coatings are typically 17-30 microns thick.

The relative amounts of the components are important in achieving above 77 K superconductivity as demonstrated by the following data:

| Y₁Ba₂Cu₃Oₓ (g) | Silver Powder (g) | Properties (T_{c}) |
|---|---|---|
| 1 | 0.01 | - (Too Brittle) |
| 1 | 0.05 | - (Too Brittle) |
| 1 | 0.10 | 90 K |
| 1 | 0.20 | 92 K |
| 1 | 0.30 | 90 K |
| 1 | 0.50 | - (Metallic) |

Following the above procedure using Sn in place of silver also provided coatings which were superconducting at liquid nitrogen temperature.

Substitution with other superconducting oxides such as Ho₁Ba₂Cu₃Oₓ, Dy₁Ba₂Cu₃Oₓ and La_{1.8}Ba_{0.2}Cu₁Oₓ for Y₁Ba₂Cu₃Oₓ provided superconducting coatings with T_{c} at 90 K, 90 K and 40 K, respectively. Other lanthanum elements such as Nd, Sm, Eu, Gd, Er, Tm, Yb and Lu are also expected to work in place of Y in Y₁Ba₂Cu₃Oₓ.

The above silver mixture spin coated onto aluminum oxide and sapphire substrates gave superconducting coatings at 90° K.

When non-fluorinated phenolic and acrylic polymeric binders were used instead of the fluoroacrylate polymer, coatings with substantially lowered superconductive transition temperatures were obtained due to carbonizing of those polymers during the heating process. Where the fluorinated polymer is used, the heating removes it without substantial carbon residue, leaving a coating consisting essentially of the superconducting ceramic and the metal.

It should be noted that when the foregoing procedures were used to make coatings without the use of the metal particles, the resulting coatings were brittle and did not adhere to the substrate. In like manner, when no polymer was added to the coating composition, the resulting coatings were less uniform and inclined to form pin holes, particularly upon spin coating. The use of the polymer in the process is necessary for the resulting coating to be continuous.

The use of the above process provides for the first time novel articles of manufacture, i.e., substrates having a durable, adherent and continuous superconductive coating thereon, said coating consisting essentially of a ceramic superconductive material and from 10-40% by weight thereof of a metal.

## Claims

1. A process for applying an adherent, durable and continuous electrically superconducting coating to a substrate, said process comprising:
suspending in an organic solvent ceramic superconducting particles;
applying said suspension to the substrate; and
drying the coating to remove the solvent;
**characterised in that:**
said ceramic superconducting particles are less than 10 microns in diameter;
metal particles less than 10 microns in diameter are suspended in said solvent;
the metal present in the form of particles is an amount from 10% to 40% by weight of the ceramic;
fluorinated organic polymer soluble in said solvent is present; and
after drying, the substrate and coating are heated to remove said fluorinated organic polymer.

2. A process as claimed in claim 1 wherein the removal of the solvent and the organic polymer is followed by annealing in the presence of oxygen.

3. A process as claimed in any preceding claim wherein the solvent is removed by gradual heating to 100°C and holding at that temperature for several hours, and then by heating at 400°C for from 1 to 12 hours to remove the organic polymer.

4. A process as claimed in claim 1 or claim 2 wherein, after heating to remove the solvent and organic polymer, the coating is heated at 900°C in oxygen for from 12 to 24 hours and then slowly cooled at the rate of about 100°C per hour to 300°C in oxygen before removing it from the oven.

5. A process as claimed in any one of claims 1 to 4 wherein the metal is silver, tin or gold.

6. A process as claimed in any one of claims 1 to 5 wherein the organic polymer is a fluoroalkyl-acrylic acid ester.

7. A process as claimed in any one of claims 1 to 6 wherein an organic dispersant (surfactant) is added to the formulation.

8. A process as claimed in any one of claims 1 to 7 wherein the solvent is methyl ethyl ketone.

## Patentansprüche

1. Ein Prozeß für das Auftragen einer dauerhaften, festhaftenden und kontinuierlichen, elektrisch supraleitenden Beschichtung auf ein Substrat; wobei dieser Prozeß folgendes umfaßt:
Einleiten von supraleitenden Keramikpartikeln in ein organisches Lösungsmittel; Auftragen dieser Suspension auf das Substrat; und Trocknen der Beschichtung zur Entfernung des Lösungsmittels;
dadurch charakterisiert, daß
diese supraleitenden Keramikpartikel einen Durchmesser von weniger als 10 Mikron aufweisen;
daß Metallpartikel, die einen Durchmesser von weniger als 10 Mikron aufweisen, in dieses Lösungsmittel eingeleitet werden;
daß das in Form von Partikeln vorhandene Metall eine Menge von 10 bis 40 Gewichtsprozent des Keramikmaterials ausmacht;
daß ein fluoriertes organisches Polymer, welches in diesem Lösungsmittel löslich ist, vorhanden ist;
und daß nach dem Trocknen das Substrat und die Beschichtung erhitzt werden, um so das fluorierte organische Polymer wieder zu beseitigen.

2. Ein Prozeß, wie er in Anspruch 1 beschrieben ist, wobei nach dem Entfernen des Lösungsmittels und des organischen Polymers ein Aufglühen unter Vorhandensein von Sauerstoff folgt.

3. Ein Prozeß, wie er in den vorangegangenen Ansprüchen beschrieben wird, wobei das Lösungsmittel durch schrittweises Erhitzen auf 100°C gebracht und auf dieser Temperatur mehrere Stunden lang gehalten wird und anschließend auf 400°C erhitzt und auf dieser Temperatur zwischen 1 und 12 Stunden gehalten wird, um das organische Polymer zu entfernen.

4. Ein Prozeß, wie er in Anspruch 1 oder 2 beschrieben wird, wobei, nach der Erhitzung zur Entfernung des Lösungsmittels und des organischen Polymers, die Beschichtung auf 900°C unter Vorhandensein von Sauerstoff erhitzt und auf dieser Temperatur zwischen 12 und 24 Stunden gehalten wird und anschließend um etwa 100°C pro Stunde auf 300°C unter Vorhandensein von Sauerstoff abgekühlt wird, bevor sie aus dem Ofen genommen wird.

5. Ein Prozeß in Übereinstimmung mit den Ansprüchen 1 bis 4, wobei es sich beim Metall um Silber, Zinn oder Gold handelt.

6. Ein Prozeß in Übereinstimmung mit den Ansprüchen 1 bis 5, wobei es sich beim organischen Polymer um ein fluoro-alkoholakrylisches Säureester handelt.

7. Ein Prozeß in Übereinstimmung mit den Ansprüchen 1 bis 6, wobei der Formel ein organisches Dispersionsmittel (Tensid) zugefügt wird.

8. Ein Prozeß in Übereinstimmung mit den Ansprüchen 1 bis 7, wobei es sich beim Lösungsmittel um Methyläthylketon handelt.

## Revendications

1. Procédé d'application d'un revêtement supraconducteur adhérent, durable et continu sur un substrat, ledit procédé comprenant:
la suspension dans un solvant organique de particules céramiques supraconductrices;
l'application de ladite suspension sur le substrat; et
le séchage du revêtement pour supprimer le solvant;
caractérisé en ce que:
lesdites particules céramiques supraconductrices ont un diamètre inférieur à 10 microns;
les particules métalliques ayant un diamètre inférieur à 10 microns sont suspendues dans ledit solvant;
le métal présent sous forme de particules représente une quantité allant de 10% à 40% en poids de la céramique;
le polymère organique fluoré soluble dans ledit solvant est présent et, après séchage, le substrat et le revêtement sont chauffés pour supprimer ledit polymère organique fluoré.

2. Procédé selon la revendication 1, dans lequel la suppression du solvant et du polymère organique est suivie d'un recuit en présence d'oxygène.

3. Procédé selon l'une quelconque des revendications précédentes, dans lequel le solvant est supprimé par un chauffage graduel jusqu'à 100°C et un maintien à cette température pendant plusieurs heures, et ensuite, par un chauffage à 400°C pendant 1 à 12 heures pour supprimer le polymère organique.

4. Procédé selon l'une des revendications 1 ou 2, dans lequel, après le chauffage pour supprimer le solvant et le polymère organique, le revêtement est chauffé à 900°C dans de l'oxygène pendant 12 à 24 heures et ensuite refroidi lentement à la cadence d'environ 100°C par heure jusqu'à 300°C dans de l'oxygène avant d'être enlevé du four.

5. Procédé selon l'une quelconque des revendications 1 à 4, dans lequel le métal est de l'argent, de l'étain ou de l'or.

6. Procédé selon l'une quelconque des revendications 1 à 5, dans lequel le polymère organique est un ester d'acide acrylique-fluoroalcoyle.

7. Procédé selon l'une quelconque des revendications 1 à 6, dans lequel un dispersant organique (surfactant) est ajouté à la formulation.

8. Procédé selon l'une quelconque des revendications 1 à 7, dans lequel le solvant est de la cétone de méthyle et d'éthyle.
